# EUROPEAN PATENT APPLICATION

(11) **EP 4 790 450 A1**
(43) Date of publication of application: **12.08.2026**
(21) Application number: 26152314.6
(22) Date of filing: 16.01.2026
(51) Int. Cl.: G01S 7/481, G01S 7/497, H01S 5/068

(54) **LASER TEMPERATURE CONTROL SYSTEM AND METHOD**

(30) Priority: 10.02.2025 US 202519049845
(71) Applicant: Honeywell International Inc., Charlotte, NC 28202 (US)
(72) Inventor: GAO, Kaizhong, Charlotte, 28202 (US)
(74) Representative: Haseltine Lake Kempner LLP

(57) **Abstract**

A system comprises a processor hosting a program module including a laser temperature control algorithm; a laser device in communication with the processor, and operative to emit a laser beam; and a laser heating/cooling unit coupled to the laser device, and in communication with the processor. At least one first temperature sensor communicates with the processor, and is configured to measure a temperature of the laser device. Optionally, one or more second temperature sensors communicate with the processor and are configured to measure a temperature of the laser heating/cooling unit. At least one third temperature sensor communicates with the processor, and is configured to measure a temperature of an ambient environment external to the laser device. The laser temperature control algorithm is operative to perform a warm-up process during a start-up of the laser device, and a cooling process during operation of the laser device.

## Description

### BACKGROUND

Some light detection and ranging (LiDAR) technologies necessitate the use of stable laser sources with a narrow linewidth and high-power output. The control and maintenance of laser temperature within a desired range are critical, given the high-temperature sensitivity typically exhibited by laser operations. For example, most lasers operate optimally within a specific temperature range, and deviating from this temperature range can lead to various issues. When the temperature is low, the laser's efficiency may decrease, leading to a reduction in output power. This degradation in output power can impact the optical signal, thereby reducing the laser system's signal-to-noise ratio.

In addition, variations in temperature can cause the laser's frequency to drift or shift from its desired value, which can negatively affect the sensitivity of sensor systems using the laser. Also, severe temperature fluctuations can trigger mode hopping, where the laser alternates between different operational modes, potentially affecting the quality of the beam. In addition to temperature-related issues, uncontrolled operating conditions can give rise to several other performance and reliability issues of lasers.

Some LiDAR systems utilize a high-power laser with integrated thermal management systems, which encompass preheating and cooling mechanisms to mitigate temperature-related issues for maintaining a stable temperature. However, some operating conditions such as temperature and pressure can vary significantly, especially in applications on aircraft, or under extreme cold weather.

In other systems, the laser incorporates a built-in Proportional-Integral-Derivative (PID) controller that attempts to adjust the temperature based on sensor measurements. However, due to rapid fluctuations in external temperature and pressure, current approaches still necessitate a significant warm-up period, such as more than 40 minutes, before the system can operate effectively. This delay limits the operation window and remains a concern for users, especially in time-sensitive applications.

Thus, there is a need for more efficient temperature control strategies, to improve a laser system's responsiveness and overall performance.

### SUMMARY

A system comprises a processor hosting a program module including a laser temperature control algorithm; a laser device in operative communication with the processor, and operative to emit a laser beam; and a laser heating/cooling unit operatively coupled to the laser device, and in operative communication with the processor. At least one first temperature sensor is in operative communication with the processor, and is configured to measure a temperature of the laser device. Optionally, one or more second temperature sensors is in operative communication with the processor and configured to measure a temperature of the laser heating/cooling unit. At least one third temperature sensor is in operative communication with the processor, and is configured to measure a temperature of an ambient environment external to the laser device. The laser temperature control algorithm is operative to perform a warm-up process during a start-up of the laser device, and a cooling process during operation of the laser device.

### BRIEF DESCRIPTION OF THE DRAWINGS

Features of the present invention will become apparent to those skilled in the art from the following description with reference to the drawings. Understanding that the drawings depict only typical embodiments and are not therefore to be considered limiting in scope, the invention will be described with additional specificity and detail through the use of the accompanying drawings, in which:
Figure 1 is a block diagram of a system for laser temperature control, according to one embodiment;
Figure 2 is a flow diagram of a process for performing a warm-up function during start-up of a laser device, according to one implementation;
Figure 3 is a flow diagram of a process for performing a cooling function during operation of a laser device, according to another implementation;
Figure 4 is a graph showing a warm-up and operation of a laser device on a cold temperature day, such as by using the system of Figure 1, according to one example;
Figure 5 is a graph showing a warm-up and operation of a laser device on an average temperature day, such as by using the system of Figure 1, according to another example;
Figure 6 is a graph showing a warm-up and operation of a laser device on a cold temperature day, with the temperature changing rapidly over time, such as by using the system of Figure 1, according to a further example;
Figure 7 is a graph showing a warm-up and operation of a laser device on an average temperature day, with the temperature changing rapidly over time, such as by using the system of Figure 1, according to another further example;
Figure 8 is a block diagram of part of an integrated control module in a laser subsystem, according to one embodiment;
Figure 9 is a block diagram of a system for laser temperature control, according to another embodiment;
Figure 10 is a flow diagram of a method for performing a warm-up function for a laser, according to another implementation; and
Figure 11 is a flow diagram of a method for performing temperature control during operation of a laser, according to a further implementation.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

Systems and methods for laser temperature control are described herein.

In various applications, a laser system needs to reach a target temperature before operation commences. This is typically manually controlled and heavily reliant on an engineer's experience, which can lead to significant variability in preheating time. In addition, external conditions can significantly influence the time required for the laser system to reach its optimal temperature. For example, during colder months, the laser system may take more than two hours to heat up to a desired operating temperature.

In the present approach, a laser temperature control process is automated and optimized. This ensures that the laser system rapidly reaches and maintains optimal conditions during operations, irrespective of environmental changes. This approach provides swift and dependable preheating of the laser, along with precise temperature regulation of the laser. The present system is able to expedite the preheating process of the laser, and sustain the laser at an ideal operating temperature consistently.

The present system incorporates temperature sensors for both a laser chamber and the ambient environment. These temperature sensors relay measurements at a predetermined or desired frequency, which corresponds to the frequency of temperature readings. The system also includes a control system equipped with an optimized control algorithm, which directs the temperature control setup to either increase or decrease its power. One or more temperature control systems, such as a heater, a cooler, a fan, a thermoelectric cooler, or a liquid cooling system, operate based on these directives to adjust the power to the desired target frequency. The control algorithm can be housed in a chip or a micro-circuit.

A method for setting the power level of the temperature control setup via the control algorithm depends on both the ambient temperature and the device temperature. In one embodiment, the power setting employs a two-step approach. When the temperature difference between the ambient temperature and device temperature is substantial (surpassing a preset level), a power overshoot or maximum power is applied to the heating or cooling system. Once the temperature difference is reduced to a specified level, the power of the temperature control device is decreased. Based on continuous temperature measurements, the power of the temperature control device is adjusted to maintain the laser device's temperature in an optimal condition. In one embodiment, a self-learning algorithm can be used to enable precise control of the laser operation temperature based on the present approach.

In one embodiment, the device temperature, the ambient temperature, and the power of the heating/cooling settings for each operation are stored in a memory chip. The control algorithm uses this historical data to determine the optimal power settings for the temperature control element. In a further embodiment, the control algorithm calculates the rate of change in the device temperature, compares it to the current and/or past ambient temperature and device temperature, and uses this information to determine or project the new temperature setting value in the subsequent step.

In another embodiment, the control algorithm includes an embedded Proportional-Integral-Derivative (PID) controller. This controller is a type of control loop feedback mechanism commonly used in industrial control systems, albeit with a different detailed implementation. The PID controller's proportional term is represented by: $Kp \times error .$ The integral term is Ki×error_integral, and the derivative term is Kd×error_derivative. These terms are optimized based on the sensor readout and power adjustment frequency (f_{T}).

In a further embodiment, the PID controller function is integrated into the hardware via a programmable logic controller (PLC) system. The proportional terms used in the PID controller are set within a predetermined range. In yet another embodiment, the parameters selected from the control algorithm and the PID depend on the frequency of the power setting adjustment of the device. Here, the 'desired step' refers to the desired change in power settings for each adjustment.

Further details of various embodiments are described hereafter and with reference to the drawings.

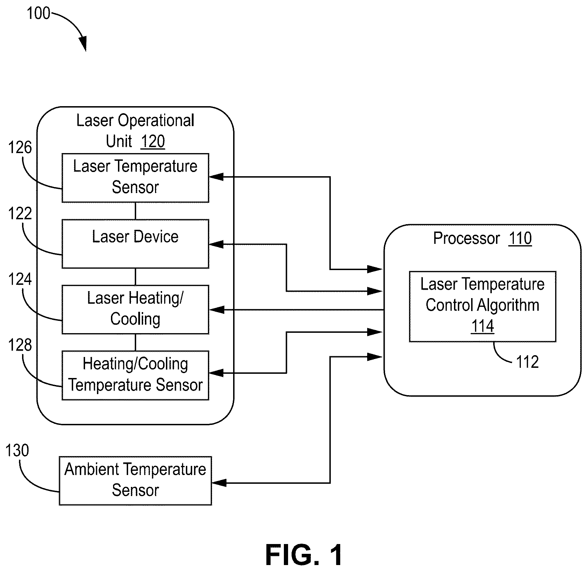

Figure 1 illustrates a system 100 for laser temperature control, according to one example embodiment. The system 100 generally includes at least one processor 110, which hosts a program module 112 that includes a laser temperature control algorithm 114. A laser operational unit 120 is operatively coupled with the processor 110. The laser operational unit 120 can be part of ground-based laser system, such as used for high-altitude atmospheric sensing. Alternatively, the laser operational unit 120 can be part of an air-data sensing system, such as onboard an aircraft.

The laser operational unit 120 includes a laser device 122 that is in operative communication with the processor 110, and is configured to emit a laser beam. The laser device 122 can be a high-powered laser, a semiconductor laser, or the like. In one embodiment, the laser device 122 can be part of a light detection and ranging (LiDAR) device. A laser heating/cooling unit 124 is operatively coupled with the laser device 122, and is in operative communication with the processor 110. The laser heating/cooling unit 124 is operative to provide heat to the laser device 122 by direct current injection to increase the current. The laser heating/cooling unit 124 is operative to provide cooling to the laser device 122 by use of a chiller, cooling fan, and the like.

In addition, the laser operational unit 120 includes at least one first temperature sensor 126, such as a laser temperature sensor (e.g., thermistor), and is configured to measure a temperature of the laser device 122. The first temperature sensor 126 is in operative communication with the processor 110, and provides temperature information to the laser temperature control algorithm 114.

Optionally, at least one second temperature sensor 128, such as a heating/cooling temperature sensor, can be configured to measure a temperature of the laser heating/cooling unit 124. The second temperature sensor 128 is in operative communication with the processor 110, and provides temperature information to the laser temperature control algorithm 114.

At least one third temperature sensor 130, such as an ambient temperature sensor, is configured to measure a temperature of an ambient environment external to the laser operational unit 120. The third temperature sensor 130 is in operative communication with the processor 110, and provides temperature information to the laser temperature control algorithm 114.

As described in further detail hereafter, the laser temperature control algorithm 114 is operative to perform a warm-up process during a start-up of the laser device 122. In addition, the laser temperature control algorithm 114 is operative to perform a cooling process during operation of the laser device 122.

When the laser device 122 is a semiconductor laser, a warm-up to a desired operating temperature of the laser employs a current injection technique. For example, by passing an electrical current through a laser diode, the laser diode device heats up due to resistance of the semiconductor material of the laser diode. The current injection technique is beneficial because it directly influences an active region of the laser diode, ensuring that the laser diode reaches an optimal temperature for efficient operation.

During operation, the temperature of the laser device 122 can increase significantly, which can affect its performance and longevity. To manage this heat, several cooling methods can be employed. For example, a liquid cooling method can be used, which involves circulating a coolant through pipes or channels that are in contact with the laser device or its heatsink. The liquid cooling method can be highly effective for high-power lasers. Another example cooling method includes air cooling with heatsinks, which are attached to the laser device to dissipate heat away from the laser device. A further example cooling method is microchannel cooling, which uses tiny channels to circulate a coolant close to an active region of the laser device, providing for efficient heat removal. In addition, combining two or more of these cooling methods can help maintain the laser device at a stable temperature, ensuring consistent performance and preventing damage.

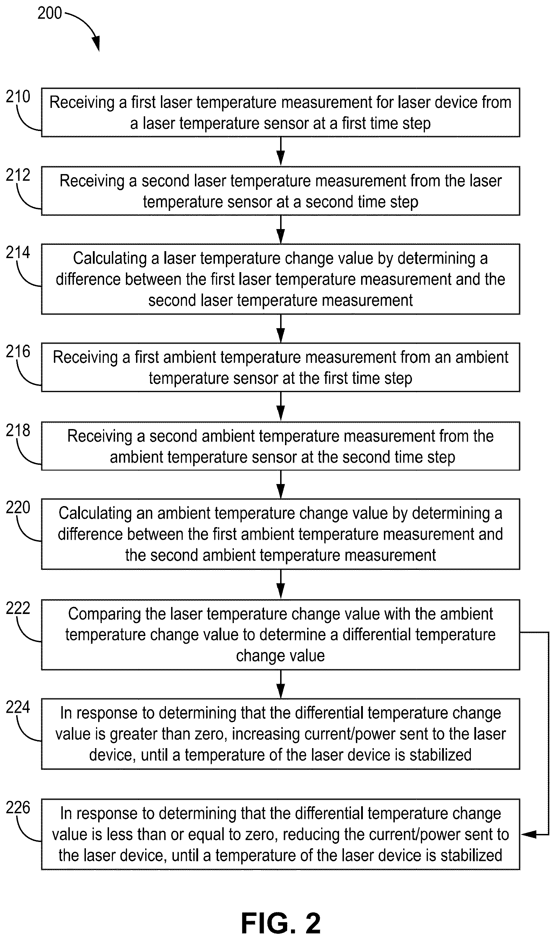

Figure 2 is a flow diagram of a process 200 for performing a warm-up function during start-up of a laser device, such as performed by laser temperature control algorithm 114 (Fig. 1), according to an example implementation. The process 200 comprises receiving a first laser temperature measurement for the laser device from a laser temperature sensor at a first time step (block 210); and receiving a second laser temperature measurement from the laser temperature sensor at a second time step (block 212). The process 200 calculates a laser temperature change value by determining a difference between the first laser temperature measurement and the second laser temperature measurement (block 214).

The process 200 also includes receiving a first ambient temperature measurement from an ambient temperature sensor at the first time step (block 216); and receiving a second ambient temperature measurement from the ambient temperature sensor at the second time step (block 218). The process 200 then calculates an ambient temperature change value by determining a difference between the first ambient temperature measurement and the second ambient temperature measurement (block 220).

It should be noted that the steps of the process 200, described for blocks 210, 212, 214, and blocks 216, 218, 220, can be performed in serial or in parallel (i.e., occur simultaneously). In addition, it should be noted that the time steps in the process 200 can be adaptive, that is, can be varied within a given range.

Thereafter, the process 200 compares the laser temperature change value with the ambient temperature change value to determine a differential temperature change value (block 222). In response to determining that the differential temperature change value is greater than zero, the process 200 increases a current/power sent to the laser device, until a temperature of the laser device is stabilized (block 224). In response to determining that the differential temperature change value is less than or equal to zero, the process 200 reduces the current/power sent to the laser device, until a temperature of the laser device is stabilized (block 226). The process 200 can be repeated for additional time steps, the duration of which can be user selected, during warm-up of the laser device.

Since the laser heater/cooler power is set after each given time step, the steps of the process 200 described for blocks 224 and 226 should not be done until a temperature of the laser device is stabilized. This should be done at the next step (when a new setting becomes available).

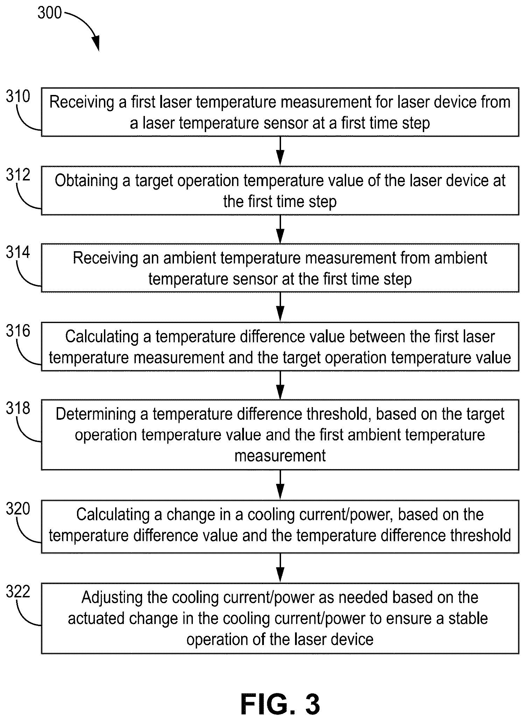

Figure 3 is a flow diagram of a process 300 for performing a cooling function during operation of a laser device, such as the laser device 122 (Fig. 1), according to another example implementation. The process 300 comprises receiving a first laser temperature measurement of the laser device from a laser temperature sensor at a first time step (block 310); and obtaining a target operation temperature value of the laser device at the first time step (block 312). The process 300 also includes receiving an ambient temperature measurement from an ambient temperature sensor at the first time step (block 314). Thereafter, the process 300 calculates a temperature difference value between the first laser temperature measurement and the target operation temperature value (block 316); and determines a temperature difference threshold, based on the target operation temperature value and the ambient temperature measurement (block 318). The process 300 then calculates a change in a cooling current/power, based on the temperature difference value and the temperature difference threshold (block 320). The process 300 adjusts the cooling current/power as needed based on the calculated change in the cooling current/power, to ensure a stable operation of the laser device (block 322). The process 300 can be repeated for additional time steps, the duration of which can be user selected, during operation of the laser device.

It should be noted that the steps of the process 300, described for blocks 310, 312, 314, 316, 318, and 320, can be performed in serial or in parallel.

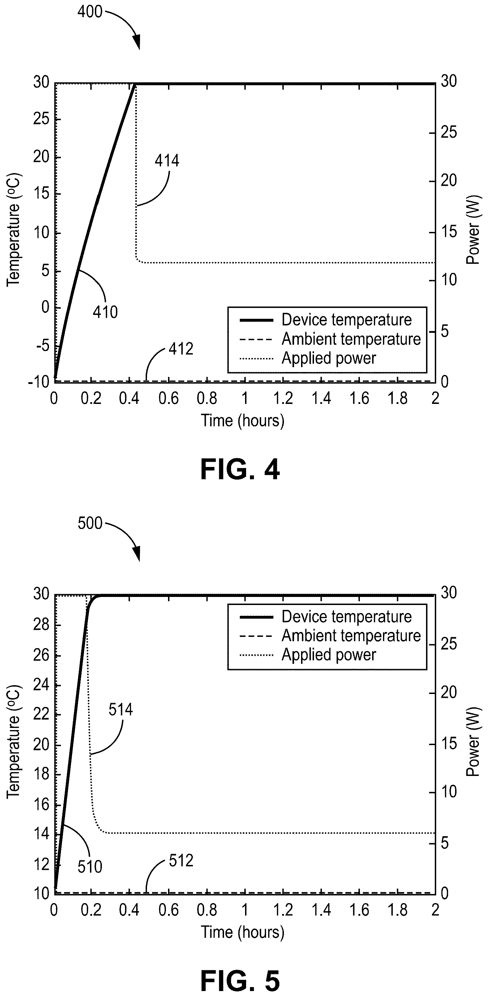

Figures 4 to 7 illustrate examples of the laser device temperature based on the algorithm and hardware architecture previously described. The results indicate that irrespective of the measurements being taken on regular or cold days, and regardless of fluctuations in the ambient temperature, the present approach empowers the laser device to achieve operational readiness swiftly and maintain optimal operating conditions consistently.

Figure 4 is a graph 400 showing a warm-up and operation of a laser device on a cold temperature day (-10 °C), such as by using the present system and method, according to one example. The graph 400 shows a temperature (°C) and power (W) with respect to time (hours). A laser device temperature is represented by a plot line 410, an ambient temperature is represented by a plot line 412, and an applied power is represented by a plot line 414. As shown, the system reaches a target laser temperature of 30 °C quickly (about 0.4 hours), when the applied power is high at the start of the warm-up operation. The applied power is then reduced after the target laser temperature is reached to maintain optimal operating conditions.

Figure 5 is a graph 500 showing a warm-up and operation of a laser device on an average temperature day (10 °C), such as by using the present system and method, according to another example. The graph 500 shows a temperature and power with respect to time. A laser device temperature is represented by a plot line 510, an ambient temperature is represented by a plot line 512, and an applied power is represented by a plot line 514. As shown, the system reaches a target laser temperature of 30 °C quickly (about 0.3 hours), when the applied power is high at the start of the warm-up operation. The applied power is then reduced after the target laser temperature is reached to maintain optimal operating conditions.

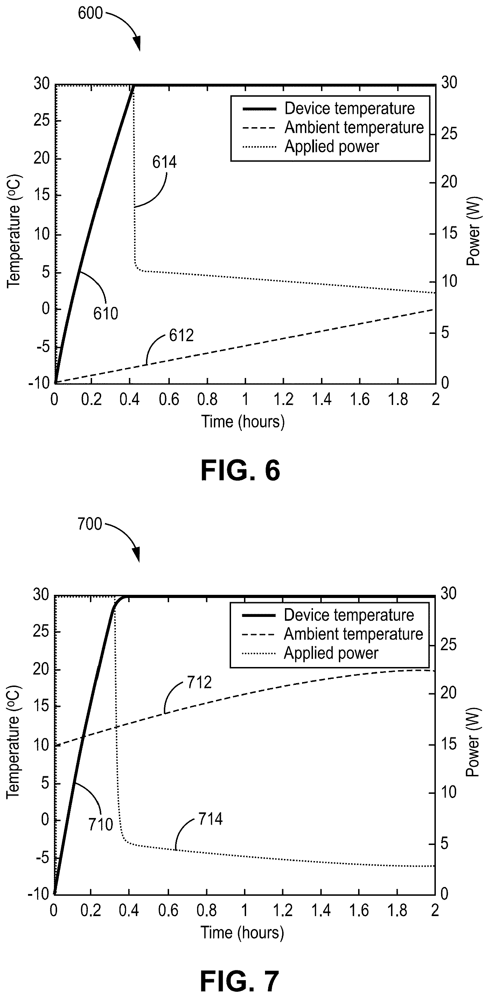

Figure 6 is a graph 600 showing a warm-up and operation of a laser device on a cold temperature day, with the temperature changing rapidly over time, such as by using the present system and method, according to a further example. The graph 600 shows a temperature and power with respect to time. A laser device temperature is represented by a plot line 610, an ambient temperature is represented by a plot line 612, and an applied power is represented by a plot line 614. As shown, the system reaches a target laser temperature of 30 °C quickly (about 0.4 hours), when the applied power is high at the start of the warm-up operation. The applied power is then reduced after the target laser temperature is reached to maintain optimal operating conditions.

Figure 7 is a graph 700 showing a warm-up operation of a laser device on an average temperature day, with the temperature changing rapidly over time, such as by using the present system and method, according to another further example. The graph 700 shows a temperature and power with respect to time. A laser device temperature is represented by a plot line 710, an ambient temperature is represented by a plot line 712, and an applied power is represented by a plot line 714. As shown, the system reaches a target laser temperature of 30 °C quickly (about 0.3 hours), when the applied power is high at the start of the warm-up operation. The applied power is then reduced after the target laser temperature is reached to maintain optimal operating conditions.

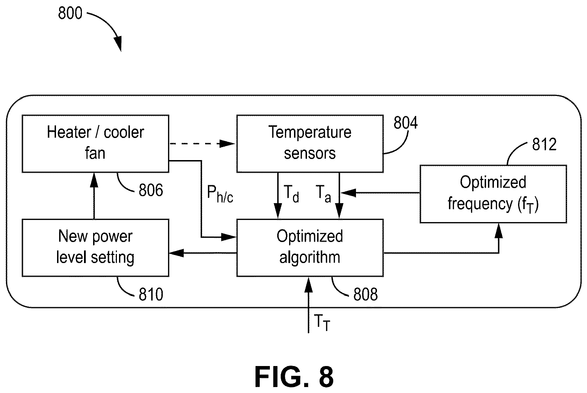

The following example embodiment of Figure 8 shows part of an integrated control module 800 in a laser subsystem, and pertains to a heater setting. However, the same approach is applicable to a chiller setting. When the laser device is in operation and the internal temperature rises, additional chilling can be needed to lower the laser temperature.

As shown in Figure 8, integrated control module 800 includes a plurality of temperature sensors 804, a heater/cooler fan unit 806 in communication with temperature sensors 804, and an optimized algorithm 808 for laser temperature control. The algorithm 808 collects heating/cooling power (P_{h/c}) from heater/cooler fan unit 806, and temperature information from temperature sensors 804, including a device temperature (T_{d}), and an ambient temperature (Tₐ). The algorithm 808 also collects a target temperature (T_{T}) of the laser device, which can be user selected. The algorithm 808 processes the collected temperature information and outputs a new power level setting at 810, which is sent to heater/cooler fan unit 806 as needed to adjust the temperature of the laser device. In addition, the algorithm 808 outputs an optimized frequency (f_{T}) at 812 that is fed back to the temperature information from temperature sensors 804.

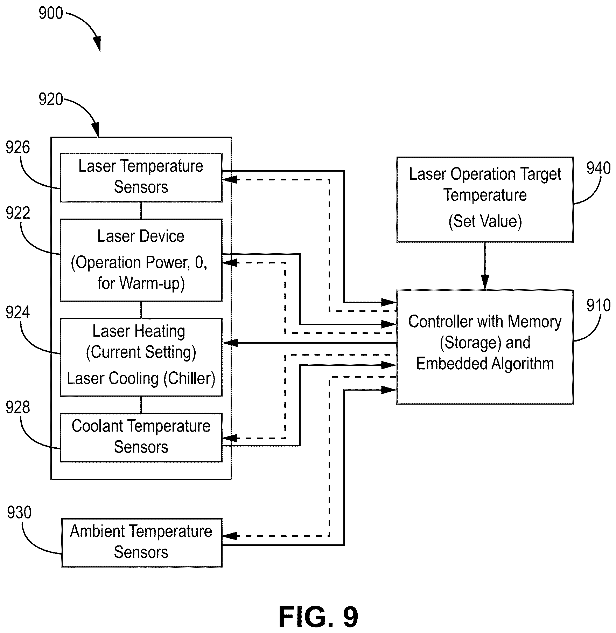

Figure 9 illustrates a system 900 for laser temperature control, according to another example embodiment. The system 900 generally includes a controller 910, which includes memory (storage) and an embedded algorithm for laser temperature control. A laser module 920 is operatively coupled with the controller 910. The laser module 920 includes a laser device 922 that is in operative communication with the controller 910. A laser heating/cooling unit 924 is operatively coupled with the laser device 922, and is in operative communication with the controller 910. The laser heating/cooling unit 924 is operative to heat the laser device 922 by direct current injection. The laser heating/cooling unit 924 is also operative to cool the laser device 922 such as by use of a chiller.

In addition, the laser module 920 includes one or more laser temperature sensors 926 configured to measure a temperature of the laser device 922. The laser temperature sensors 926 are communication with the controller 910, and provide laser temperature information to the embedded algorithm. The laser module 920 also includes one or more coolant temperature sensors 928 configured to measure a temperature of the laser heating/cooling unit 924. The coolant temperature sensors 928 are in communication with the controller 910, and provide coolant temperature information to the embedded algorithm. Also, one or more ambient temperature sensors 930 are configured to measure a temperature of an ambient environment external to the laser module 920. The ambient temperature sensors 930 are in operative communication with the controller 910, and provides ambient temperature information to the embedded algorithm.

During operation of the system 900, the temperature sensors 926, 928, 930 report temperature measurements for each time step to the controller 910, and the laser device 922 reports an operation power of zero (0) for a warm-up mode to controller 910. The controller 910 sends feedback, including the time step size utilized, to each of the temperature sensors 926, 928, 930 and the laser device 922. The temperature sensors 926, 928, 930 report temperature measurements using the time step assigned by the controller 910. The controller 910 also sends current/power settings for laser heating/cooling unit 924, to enable a laser warm-up operation, and to provide a stable temperature during normal laser operation, such as for a laser cooling operation. For example, direct current injection can be used when the laser temperature needs to be increased. An increase of the current to produce an increased laser temperature is determined by the controller 910. A laser operation target temperature 940, which is a set value, is input to the controller 910 and used by the embedded algorithm to calculate the current/power settings for the laser heating/cooling unit 924.

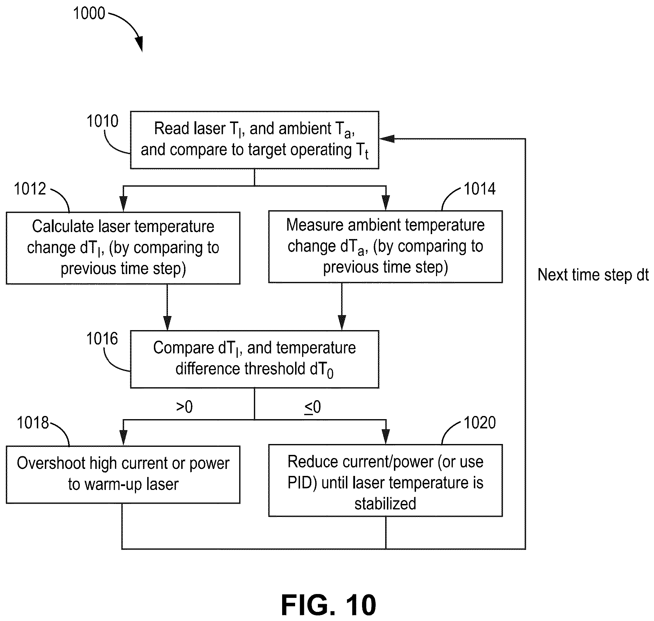

Figure 10 is a flow diagram of a method 1000 for performing a warm-up function for a laser, according to another example implementation. The method 1000 includes the steps of read a current laser temperature (T₁) and a current ambient temperature (Tₐ), and then compare the temperatures T₁ and Tₐ to a target operating temperature (Tt) for the laser (block 1010). The method 1000 calculates a laser temperature change (dT₁), by comparing the current laser temperature with the laser temperature at a previous time step (block 1012). The method 1000 also measures an ambient temperature change (dTₐ) by comparing the current ambient temperature with the ambient temperature at the previous time step (block 1014). The method 1000 then compares dT₁ and a temperature difference threshold dT₀ (which depends on Tₜ and Tₐ) (block 1016). In particular, the method 1000 can use both dT₁ and dT₀ to determine the current or power used for the next step.

In response to determining that a differential value between dT₁ and dT₀ is greater than zero, the method 1000 provides an overshoot of high current or power to warm-up the laser (block 1018). The method 1000 then repeats by returning to block 1010 at a next time step (dt). In response to determining that the differential value between dT₁ and dT₀ is less than or equal to zero, the method 1000 reduces the current/power (or uses PID) until the laser temperature is stabilized (block 1020). The method 1000 then repeats by returning to block 1010 at the next time step. The next time step can be determined by the past few time steps of the laser temperature, and the time step size may be updated as well.

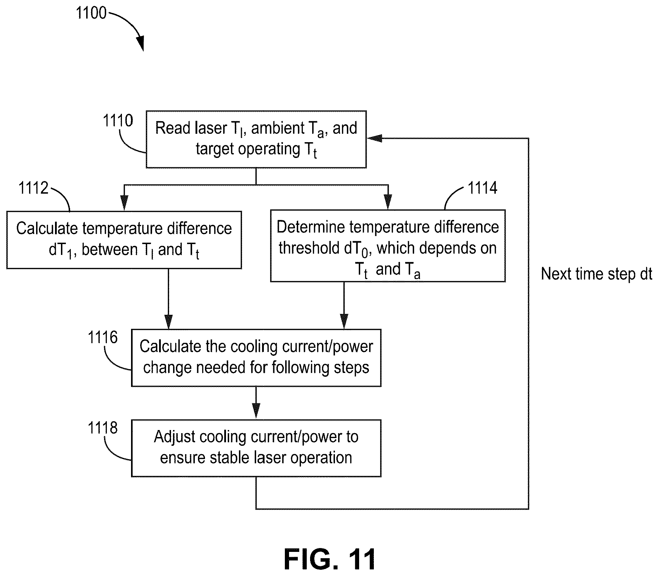

Figure 11 is a flow diagram of a method 1100 for performing temperature control during operation of a laser, according to a further example implementation. The method 1100 includes the steps of read a current laser temperature (T₁), a current ambient temperature (Tₐ), and a target operating temperature (Tt) for the laser (block 1110). The method 1100 calculates a temperature difference (dT₁) between T₁ and Tₜ (block 1112). The method 1100 determines a temperature difference threshold dT₀, which depends on Tₜ and Tₐ (block 1114). The method 1100 calculates the cooling current/power change needed for the following steps (block 1116), and adjusts the cooling current/power to ensure a stable laser operation (block 1118).

The method 1100 then repeats by returning to block 1110 at the next time step. Again, the next time step can be determined by the past few time steps of the laser temperature, and the time step size may be updated as well.

The processing units and/or other computational devices used in the method and system described herein may be implemented using software, firmware, hardware, or appropriate combinations thereof. The processing unit and/or other computational devices may be supplemented by, or incorporated in, specially designed application-specific integrated circuits (ASICs) or field programmable gate arrays (FPGAs). In some implementations, the processing unit and/or other computational devices may communicate through an additional transceiver with other computing devices outside of the navigation system, such as those associated with a management system, or computing devices associated with other subsystems controlled by the management system. The processing unit and/or other computational devices can also include or function with software programs, firmware, or other computer readable instructions for carrying out various process tasks, calculations, and control functions used in the methods and systems described herein.

The methods described herein may be implemented by computer executable instructions, such as program modules or components, which are executed by at least one processor or processing unit. Generally, program modules include routines, programs, objects, data components, data structures, algorithms, and the like, which perform particular tasks or implement particular abstract data types.

Instructions for carrying out the various process tasks, calculations, and generation of other data used in the operation of the methods described herein can be implemented in software, firmware, or other computer readable instructions. These instructions are typically stored on appropriate computer program products that include computer readable media used for storage of computer readable instructions or data structures. Such a computer readable medium may be available media that can be accessed by a general purpose or special purpose computer or processor, or any programmable logic device.

Suitable computer readable storage media may include, for example, nonvolatile memory devices including semi-conductor memory devices such as Random Access Memory (RAM), Read Only Memory (ROM), Electrically Erasable Programmable ROM (EEPROM), or flash memory devices; magnetic disks such as internal hard disks or removable disks; optical storage devices such as compact discs (CDs), digital versatile discs (DVDs), Blu-ray discs; or any other media that can be used to carry or store desired program code in the form of computer executable instructions or data structures.

### Example Embodiments

Example 1 includes a system comprising: a processor hosting a program module including a laser temperature control algorithm; a laser device in operative communication with the processor, and operative to emit a laser beam; a laser heating/cooling unit operatively coupled to the laser device, and in operative communication with the processor; at least one first temperature sensor in operative communication with the processor, and configured to measure a temperature of the laser device; optionally, at least one second temperature sensor in operative communication with the processor, and configured to measure a temperature of the laser heating/cooling unit; and at least one third temperature sensor in operative communication with the processor, and configured to measure a temperature of an ambient environment external to the laser device; wherein the laser temperature control algorithm is operative to perform a warm-up process during a start-up of the laser device, and a cooling process during operation of the laser device.

Example 2 includes the system of Example 1, wherein during the start-up of the laser device, the warm-up process comprises: receiving a first laser temperature measurement from the at least one first temperature sensor at a first time step; receiving a second laser temperature measurement from the at least one first temperature sensor at a second time step; calculating a laser temperature change value by determining a difference between the first laser temperature measurement and the second laser temperature measurement; receiving a first ambient temperature measurement from the at least one third temperature sensor at the first time step; receiving a second ambient temperature measurement from the at least one third temperature sensor at the second time step; calculating an ambient temperature change value by determining a difference between the first ambient temperature measurement and the second ambient temperature measurement; and comparing the laser temperature change value with the ambient temperature change value to determine a differential temperature change value; in response to determining that the differential temperature change value is greater than zero, increasing current/power sent to the laser device, until a temperature of the laser device is stabilized; in response to determining that the differential temperature change value is less than or equal to zero, reducing the current/power sent to the laser device, until a temperature of the laser device is stabilized.

Example 3 includes the system of Example 1, wherein during the operation of the laser device, the cooling process comprises: receiving a first laser temperature measurement from the at least one first temperature sensor at a first time step; obtaining a target operation temperature value of the laser device at the first time step; receiving a first ambient temperature measurement from the third temperature sensor at the first time step; calculating a temperature difference value between the first laser temperature measurement and the target operation temperature value; determining a temperature difference threshold, based on the target operation temperature value and the first ambient temperature measurement; calculating a change in a cooling current/power, based on the temperature difference value and the temperature difference threshold; and adjusting the cooling current/power based on the calculated change to ensure a stable operation of the laser device.

Example 4 includes the system of any of Examples 1-3, wherein a laser operational unit includes the laser device, the laser heating/cooling unit, the at least one first temperature sensor, and one or more second temperature sensors.

Example 5 includes the system of Example 4, wherein the laser operational unit is part of a ground-based laser system used for high-altitude atmospheric sensing.

Example 6 includes the system of any of Examples 4-5, wherein the laser operational unit is part of an air-data sensing system onboard an aircraft.

Example 7 includes the system of any of Examples 4-6, wherein the laser device is part of a light detection and ranging (LiDAR) device.

Example 8 includes the system of any of Examples 4-7, wherein the laser heating/cooling unit is operative to provide heat to the laser device by direct current injection.

Example 9 includes the system of any of Examples 4-8, wherein the laser heating/cooling unit is operative to provide cooling to the laser device by using a chiller, a cooling fan, liquid cooling or a coolant.

Example 10 includes the system of any of Examples 1-9, wherein the processor comprises a controller with memory.

Example 11 includes the system of Example 10, wherein the controller includes a proportional-integral-derivative (PID) controller.

Example 12 includes the system of any of Examples 10-11, wherein the controller is configured to send feedback, including a time step size utilized, to the temperature sensors and the laser device.

Example 13 includes the system of any of Examples 10-12, wherein the controller is configured to receive an operation target temperature for the laser device, which is used by the laser temperature control algorithm to calculate current/power settings for the laser heating/cooling unit.

Example 14 includes the system of Example 13, wherein the controller is configured to send the current/power settings to the laser heating/cooling unit, to enable the warm-up process during start-up of the laser device and the cooling process during operation of the laser device.

Example 15 includes a method for performing a laser warm-up operation, the method comprising: receiving a first laser temperature measurement for a laser device from a laser temperature sensor at a first time step; receiving a second laser temperature measurement from the laser temperature sensor at a second time step; calculating a laser temperature change value by determining a difference between the first laser temperature measurement and the second laser temperature measurement; receiving a first ambient temperature measurement from an ambient temperature sensor at the first time step; receiving a second ambient temperature measurement from the ambient temperature sensor at the second time step; calculating an ambient temperature change value by determining a difference between the first ambient temperature measurement and the second ambient temperature measurement; and comparing the laser temperature change value with the ambient temperature change value to determine a differential temperature change value; in response to determining that the differential temperature change value is greater than zero, increasing a current/power sent to the laser device, until a temperature of the laser device is stabilized; in response to determining that the differential temperature change value is less than or equal to zero, reducing the current/power sent to the laser device, until a temperature of the laser device is stabilized.

Example 16 includes the method of Example 15, wherein the laser device is part of a ground-based laser system used for high-altitude atmospheric sensing.

Example 17 includes the method of Example 15, wherein the laser device is part of an air-data sensing system onboard an aircraft.

Example 18 includes a method for performing a laser cooling operation, the method comprising: receiving a first laser temperature measurement for a laser device from a laser temperature sensor at a first time step; obtaining a target operation temperature value of the laser device at the first time step; receiving an ambient temperature measurement from an ambient temperature sensor at the first time step; calculating a temperature difference value between the first laser temperature measurement and the target operation temperature value; determining a temperature difference threshold, based on the target operation temperature value and the ambient temperature measurement; calculating a change in a cooling current/power, based on the temperature difference value and the temperature difference threshold; and adjusting the cooling current/power based on the calculated change in the cooling current/power, to ensure a stable operation of the laser device.

Example 19 includes the method of Example 18, wherein the laser device is part of a ground-based laser system used for high-altitude atmospheric sensing.

Example 20 includes the method of Example 18, wherein the laser device is part of an air-data sensing system onboard an aircraft.

The present invention may be embodied in other specific forms without departing from its essential characteristics. The described embodiments are to be considered in all respects only as illustrative and not restrictive. The scope of the invention is therefore indicated by the appended claims rather than by the foregoing description. All changes that come within the meaning and range of equivalency of the claims are to be embraced within their scope.

## Claims

1. A system comprising:
a processor hosting a program module including a laser temperature control algorithm;
a laser device in operative communication with the processor, and operative to emit a laser beam;
a laser heating/cooling unit operatively coupled to the laser device, and in operative communication with the processor;
at least one first temperature sensor in operative communication with the processor, and configured to measure a temperature of the laser device;
optionally, at least one second temperature sensor in operative communication with the processor, and configured to measure a temperature of the laser heating/cooling unit; and
at least one third temperature sensor in operative communication with the processor, and configured to measure a temperature of an ambient environment external to the laser device;
wherein the laser temperature control algorithm is operative to perform a warm-up process during a start-up of the laser device, and a cooling process during operation of the laser device.

2. The system of claim 1, wherein during the start-up of the laser device, the warm-up process comprises:
receiving a first laser temperature measurement from the at least one first temperature sensor at a first time step;
receiving a second laser temperature measurement from the at least one first temperature sensor at a second time step;
calculating a laser temperature change value by determining a difference between the first laser temperature measurement and the second laser temperature measurement;
receiving a first ambient temperature measurement from the at least one third temperature sensor at the first time step;
receiving a second ambient temperature measurement from the at least one third temperature sensor at the second time step;
calculating an ambient temperature change value by determining a difference between the first ambient temperature measurement and the second ambient temperature measurement; and
comparing the laser temperature change value with the ambient temperature change value to determine a differential temperature change value;
in response to determining that the differential temperature change value is greater than zero, increasing current/power sent to the laser device, until a temperature of the laser device is stabilized;
in response to determining that the differential temperature change value is less than or equal to zero, reducing the current/power sent to the laser device, until a temperature of the laser device is stabilized.

3. The system of claim 1, wherein during the operation of the laser device, the cooling process comprises:
receiving a first laser temperature measurement from the at least one first temperature sensor at a first time step;
obtaining a target operation temperature value of the laser device at the first time step;
receiving a first ambient temperature measurement from the third temperature sensor at the first time step;
calculating a temperature difference value between the first laser temperature measurement and the target operation temperature value;
determining a temperature difference threshold, based on the target operation temperature value and the first ambient temperature measurement;
calculating a change in a cooling current/power, based on the temperature difference value and the temperature difference threshold; and
adjusting the cooling current/power based on the calculated change to ensure a stable operation of the laser device.

4. The system of claim 1, wherein the processor comprises a controller with memory.

5. The system of claim 4, wherein the controller includes a proportional-integral-derivative (PID) controller.

6. The system of claim 4, wherein the controller is configured to send feedback, including a time step size utilized, to the temperature sensors and the laser device.

7. The system of claim 4, wherein the controller is configured to receive an operation target temperature for the laser device, which is used by the laser temperature control algorithm to calculate current/power settings for the laser heating/cooling unit.

8. The system of claim 7, wherein the controller is configured to send the current/power settings to the laser heating/cooling unit, to enable the warm-up process during start-up of the laser device and the cooling process during operation of the laser device.

9. A method for performing a laser warm-up operation, the method comprising:
receiving a first laser temperature measurement for a laser device from a laser temperature sensor at a first time step;
receiving a second laser temperature measurement from the laser temperature sensor at a second time step;
calculating a laser temperature change value by determining a difference between the first laser temperature measurement and the second laser temperature measurement;
receiving a first ambient temperature measurement from an ambient temperature sensor at the first time step;
receiving a second ambient temperature measurement from the ambient temperature sensor at the second time step;
calculating an ambient temperature change value by determining a difference between the first ambient temperature measurement and the second ambient temperature measurement; and
comparing the laser temperature change value with the ambient temperature change value to determine a differential temperature change value;
in response to determining that the differential temperature change value is greater than zero, increasing a current/power sent to the laser device, until a temperature of the laser device is stabilized;
in response to determining that the differential temperature change value is less than or equal to zero, reducing the current/power sent to the laser device, until a temperature of the laser device is stabilized.

10. A method for performing a laser cooling operation, the method comprising:
receiving a first laser temperature measurement for a laser device from a laser temperature sensor at a first time step;
obtaining a target operation temperature value of the laser device at the first time step;
receiving an ambient temperature measurement from an ambient temperature sensor at the first time step;
calculating a temperature difference value between the first laser temperature measurement and the target operation temperature value;
determining a temperature difference threshold, based on the target operation temperature value and the ambient temperature measurement;
calculating a change in a cooling current/power, based on the temperature difference value and the temperature difference threshold; and
adjusting the cooling current/power based on the calculated change in the cooling current/power, to ensure a stable operation of the laser device.
